Europäisches Patentamt

European Patent Office

Office européen des brevets

(11) Publication number : 0 516 364 A2

# EUROPEAN PATENT APPLICATION

(21) Application number : 92304737.7

(22) Date of filing : 26.05.92

(51) Int. Cl.⁵ : G11C 29/00

(30) Priority : 28.05.91 JP 152391/91

(43) Date of publication of application :
02.12.92 Bulletin 92/49

(84) Designated Contracting States :
DE FR GB IT NL

(71) Applicant : TEXAS INSTRUMENTS
INCORPORATED
13500 North Central Expressway
Dallas Texas 75265 (US)

(72) Inventor : Sakamoto, Harumi
864 Ohyama Miho-mura
Inashiki-gun Ibaraki-ken (JP)

(74) Representative : Blanco White, Henry Nicholas
et al
ABEL & IMRAY Northumberland House
303-306 High Holborn
London WC1V 7LH (GB)

(54) Semiconductor memory device having burn-in test circuit.

(57)    This invention provides a type of semiconductor device and its test method characterized by the fact that the test can be performed in a simple operation with a simple device configuration by applying the test signals independent of the pin configuration of the semiconductor devices.

For the semiconductor devices for which this invention is applicable, the positions of the pins for application of the test signals of the field memory, such as VDD, TBIN, VSS, PSWCK, PPOR, are the same for both the 36-pin DIP type and the 70-pin DIP type. In addition, switching circuits (3), (5), (6), (7) for switching the test signals in the field memory and the conventional operation signal and the test data generating circuit (4) are incorporated in the field memory. When the burn-in test signal BIN that indicates the test mode is applied, and the signals for generating the test data and for controlling the test are applied, the test data are generated automatically in the field memory, the test data are stored in the memory cells on the base of the test signals, and are read out for assessment. In the burn-in test mode, the power source voltage VDD applied is higher than the conventional operation voltage.

Fig.6

EP 0 516 364 A2

This invention concerns testing of the internal circuit of semiconductor device. More specifically, this invention concerns a test method of semiconductor device which is independent of the pin configuration of the semiconductor device and can perform the burn-in test effectively.

## PRIOR ART

For semiconductor devices, before they are shipped, in order to screen for defective parts, such as poor gate circuit, capacitor insulating film, etc., the elements are placed in a high temperature of about 125°C, and the power source terminal is connected to a voltage higher than the conventional power source voltage (such as 5 VDC), such as 7-7.5 VDC, for accelerated testing (this test is called 'burn-in test').

In this burn-in test, a plurality of test signals are applied to the various pins of the semiconductor device to be tested via a burn-in test board.

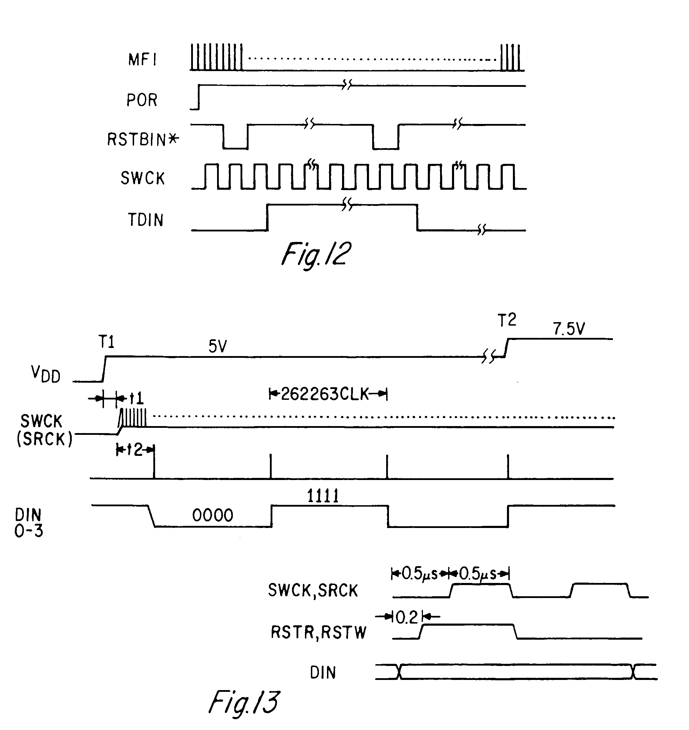

Figure 13 shows a timing diagram of the burn-in test signals in the field memory.

As shown in this figure, at time point T1, a power source voltage $V_{dd}$, usually 5 VDC, is applied to the field memory. After a prescribed time t1, serial write clock SWCK is applied. After a prescribed time t2, reset write pulse RSTW is applied. The reset write pulse is applied periodically for every 262 or 263 serial write clock SWCK. Each time when reset write pulse RSTW is applied, the 4-bit test data DIN, '0000' and '1111', are applied and are stored in the memory cells of the field memory.

At time point T2, the power source voltage $V_{dd}$ rises to 7.5 VDC, and the burn-in test is started. Before time point T2, serial write clock SWCK and serial read clock SRCK, reset write pulse RSTW and reset read. pulse RSTR are applied, and write and read of the aforementioned data DIN are carried out to from the aforementioned memory cells. From the results of read, it is determined whether the field memory is damaged in the burn-in test or operates normally.

As the power source voltage $V_{dd}$ rises, the voltages applied to the various elements in the device are also increased, and the elements are in the overload state.

## PROBLEMS TO BE SOLVED BY THE INVENTION

In this burn-in test, the content of the test signals depends on the type of the semiconductor device to be tested. In addition, the positions of the test signal application pins also depend on the pin configuration of the semiconductor device to be tested.

Consequently, for each type of semiconductor-device, a specific burn-in test board should be manufactured, and the test time is long. These are problems.

In addition, in order to send the aforementioned test signals from outside the semiconductor device into the semiconductor device with the aforementioned timing, a complicated burn-in test board is needed. This is also a problem.

## OBJECT OF THE INVENTION

An object of the present invention is to offer a type of semiconductor device characterized by the following facts: power source terminal, clock application terminal and test mode application terminal are positioned at the common terminal position of the semiconductor device; the aforementioned semiconductor device has a test signal generating circuit which generates signals for testing of the internal circuit on the basis of the signals applied from the aforementioned terminals; based on the signals applied from the aforementioned terminals, the aforementioned signal generating circuit generates the test signals, and based on the test signals, the circuit in the interior of the aforementioned semiconductor device is tested.

In addition, this invention also provides a test method of a semiconductor device characterized by the following facts: when the internal circuit of the semiconductor device is tested, power source voltage, clock and test mode signals are input, the signals needed for testing the aforementioned internal circuit are generated by a test signal generating circuit in the semiconductor device, and are used to carry out the testing of the internal circuit of the aforementioned semiconductor device.

For semiconductor device, first of all the test signal generating circuit needed for testing the internal circuit is formed. For the semiconductor device, the terminals to which the least signals needed for operating the test signal generating circuit, that is, the power source voltage, clock and test mode signal, are applied are defined as the common pins with the semiconductor device. Consequently, even for different types of semiconductor devices, the test signals can be applied to the same pins.

For the semiconductor device with this configuration, by applying the corresponding test signals on the aforementioned pins, test signals are generated by the test signal generating circuit formed in the semiconductor device, and the test signals generated are applied to the internal circuit of the semiconductor device.

The results after application of the test signals can be found by monitoring the output pins of the semiconductor device.

## BRIEF DESCRIPTION OF THE DRAWINGS

Figure 1 is a diagram illustrating the pin configurations of the 70-pin and 36-pin devices in Application Example 1 of the semiconductor device and its test equipment of this invention.

Figure 2 is a circuit diagram of the circuit that generates the reset burn-in test signal in the application examples of this invention.

Figure 3 is a diagram of a circuit which generates the internal clock in the application examples of this invention.

Figure 4 is a timing diagram of generation of the reset burn-in test signal of Figure 2.

Figure 5 is a diagram of the switching circuit which switches the reset burn-in test signal and the externally applied reset write pulse in the application examples of this invention.

Figure 6 is a diagram of the circuit which generates the test data in the application examples of this invention.

Figure 7 is a timing diagram of the test data.

Figure 8 is a diagram of the circuit which switches the test data and the external data in the application example of this invention.

Figure 9 is a diagram of the switching circuit which switches the internally generated 'high'-level signal and the external write enable in the application examples of this invention.

Fig 10 is a diagram of the circuit which switches the internal clock and the external serial read clock in the application examples of this invention.

Figure 11 is a diagram of the circuit which generates the burn-in test signal and serial write clock in the application examples of this invention.

Fig 12 is a timing diagram of the signal generation in the circuit of Figure 11.

Figure 13 is a timing diagram of the test signals applied from the exterior in the test of the conventional semiconductor device.

In reference numerals as shown in the drawings:

1. Burn-in test signal generating circuit
2. Internal clock generating circuit
3. Reset burn-in test signal switching circuit
4. 4A, test data signal generating circuit
5. Test data signal switching circuit
6. Signal switching circuit
7. Internal clock signal switching circuit
8. Serial write clock generating circuit

## DESCRIPTION OF THE PREFERRED EMBODIMENTS

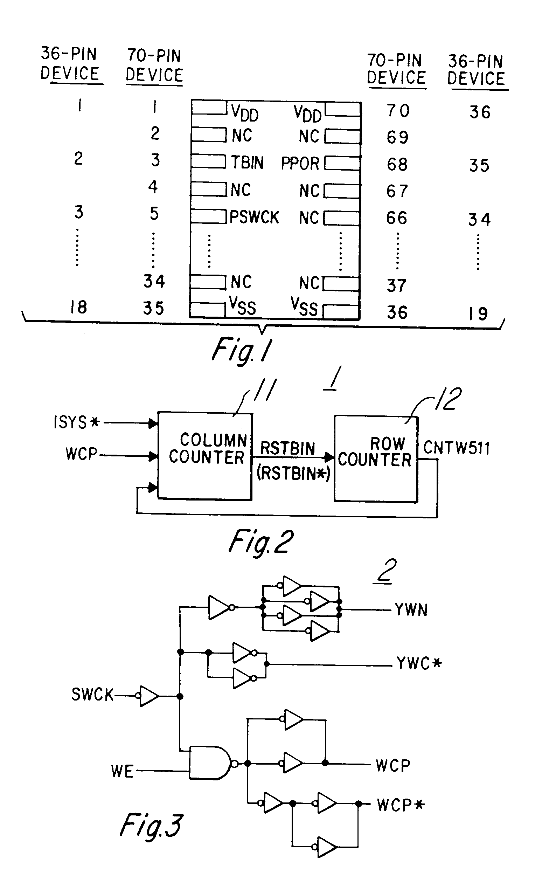

Figure 1 shown the DIP-format pin positions of the field memory in Application Example 1 of the semiconductor device and its test equipment in this invention. In this application example, for both the 70-pin and 36-pin devices, the following pins are shown: power source voltage pins VDD, VSS for application of power source voltages VDD, VSS, pin PSWCK for application of serial write clock SWCK, pin TBIN for application of burn-in test signal BIN, and pin PPOR for application of power on reset signal POR. The pins other than the aforementioned pins are set in the open state (NC).

For the 70-pin and 36-pin devices, the distances between the adjacent pins are different from each other (20 mil pitch and 40 mil pitch respectively). However, the power source voltage pins VDD, VSS for application of power source voltages VDD, VSS, pin PSWCK for application of serial write clock SWCK, pin TBIN for application of burn-in test signal BIN, and pin PPOR for application of power on reset signal POR are at the same positions. That is, for both the 36-pin and 70-pin devices, it is possible to apply the test signals at the same pin positions. As a result, it is only needed to manufacture one type of burn-in test board, and this single type of burn-in test board can be used for testing a plurality of semiconductor devices.

Figure 2 shows the configuration diagram of circuit (1) which generates reset burn-in test signal RSTBIN formed in the field memory. This reset burn-in test signal generating circuit (1) is made of column counter (11) and row counter (12). Input into column counter (11) are the initial system signal ISYS* (*represents signal inversion) that drives the power reset signal POR and write count pulse WCP. As shown in Figure 3, this write count pulse WCP is generated by internal clock generating circuit (2). Generally speaking, it is signal formed as the AND signal of the serial write clock SWCK and write enable WE.

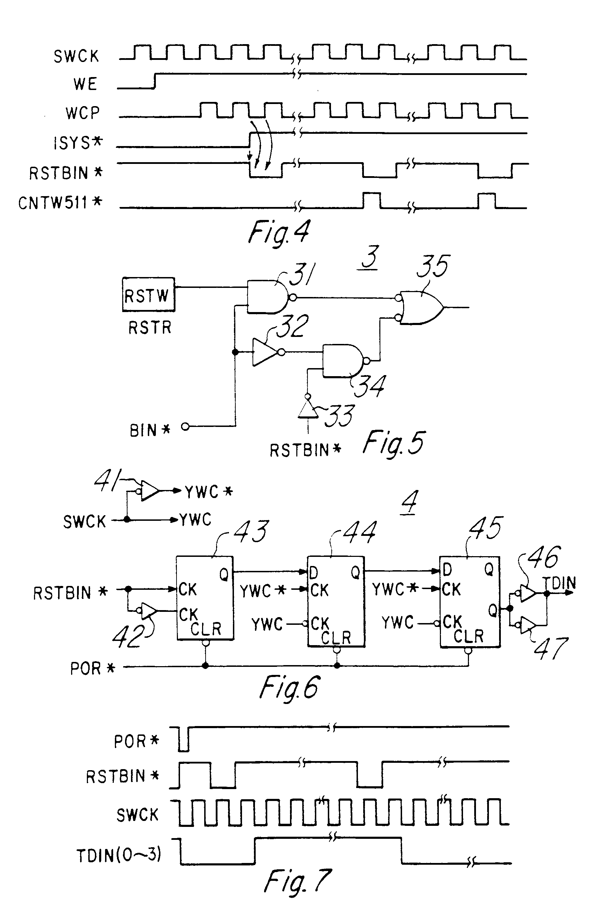

Figure 4 shows the timing diagram for generation of reset burn-in test signal RSTBIN. This reset burn-in test signal RSTBIN is then applied to the circuit to be described later.

Figure 5 shows the configuration of the switch signal switch circuit (3) which switches said reset burn-in test signal RSTBIN and the reset write signal RSTW or reset read signal RTTR applied via the bonding pad from the exterior in the conventional operation of the field memory.

This signal switch circuit (3) is formed within the field memory, and consists of inverters (32), (33), NAND gates (31), (34) and NOR gate (35).

In the burn-in test mode, from outside the field memory, and via said burn-in test signal application pin TBIN, a 'low'-level burn-in reset signal BIN* is applied, and the aforementioned reset burn-in test signal RSTBIN* is output from NOR gate (35).

In the conventional operation mode, the burn-in test signal BIN* is on the 'high'-level; signal switching circuit (3) outputs from the bonding pad the reset write signal RSTW or reset read signal RSTR applied in the conventional operation.

In this way, in the burn-in test mode, reset burn-in test signal RSTBIN* is applied to the internal control circuit of the field memory. In the conventional operation mode, reset write signal RSTW or rest read signal RSTR is applied.

Figure 6 shows the circuit diagram of test data generating circuit (4) formed in the field memory. This test data generating circuit (4) consists of inverters (41), (42), (46), (47), as well as T flipflop (TFF) (43), and delay flipflops (DFF) (44), (45). Inverters (46), (47) act as driver circuits.

Figure 7 shows the timing diagram of the test data generated at this test data generating circuit (4).

When 'low'-level power-on reset signal POR* is applied from pin PPOR for application of power-on reset signal POR, said FF (43)-(45) are reset. Then, when the aforementioned reset burn-in test signal RSTBIN* is applied, corresponding to the serial write clock SWCK applied from pin PSWCK for application of the write clock, the 4-bit internal test data TDIN is output. The test date TDIN are data alternating between '0000' and '1111'.

For the internal data TDIN, in the burn-in test mode, storage is performed in the memory cells in the field memory.

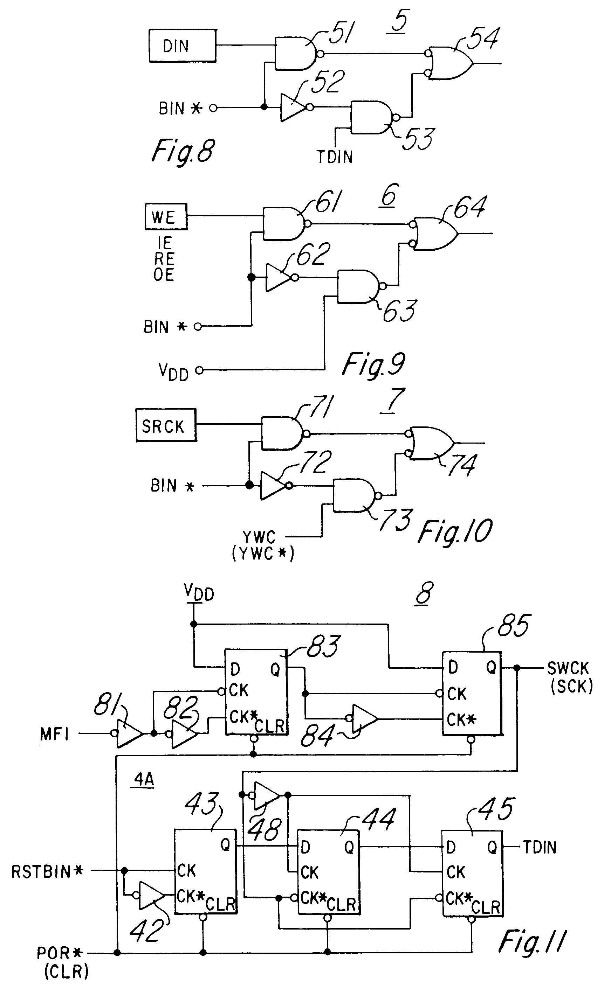

Internally generated test data TDIN are applied to signal switching circuit (5) as shown in Figure 8. Signal switch circuit (5) is made of NAND gates (51), (53), inverter (52), and NOR gate (54).

Just as in the case of signal switch circuit (3) shown in Figure 5, for this signal switch circuit (5), in the burn-in test mode, when a 'low'-level burn-in test signal BIN* is applied, the aforementioned internal test data TDIN are output; in the conventional operation mode, when a 'high'-level burn-in test BIN* is applied, data DIN applied from the outside via the bonding pad are output. These data are applied to the memory cells of the field memory. In the burn-in test, the test data TDIN of '0' and '1' are recorded continuously in the memory cells in an alternating way.

Figure 9 shows signal switching circuit (6) which switches the write enable WE and the internally generated 'high'-level signal. Signal switching circuit (6) consists of NAND gates (61), (63), inverter (62), and NOR gate (64).

In the burn-in test mode, when 'low'-level burn-in test signal BIN* is applied, a 'high'-level signal [higher] than the power source voltage VDD applied to power source pin VDD is always output. In the conventional operation mode, when a 'high'-level burn-in test signal BIN* is applied, the write enable WE applied from the exterior is output via the bonding pad.

With the aid of the same signal switching circuit (6) as the signal switching circuit that switches the write enable WE as shown in Figure 9, read enable RE, input enable IE, output enable OE, and other signals are also formed in the field memory. Just as with the aforementioned signal switching circuit (6), these signal switching circuits also always output a 'high'-level signal in the burn-in test mode.

Figure 10 shows switching circuit (7) which switches the internal clock YWC (YWC*) from clock generating circuit (5) shown in Figure 3 and the serial read clock SRCK applied from the exterior. This signal switching circuit (7) is also formed in the field memory.

Signal switching circuit (7) has NAND gates (71), (73), inverter (72) and NOR gate (74). In the burn-in test mode, when 'low'-level burn-in test signal BIN* is applied, said clock YWC (YWC*) is output; in the conventional operation mode, as 'high'-level burn-in test signal BIN* is applied, the conventional serial read clock SRCK applied via the bonding pad is output.

By using the aforementioned circuits, with the aid of the test signals from outside the field memory, it is possible to carry out accelerated testing of the memory cells in the field memory, their control circuit, and other internal circuits.

In the burn-in test mode, the power source voltage VDD is usually higher than the conventional operation mode's power source voltage (such as 5 VDC), and is applied as 7-7.5 VDC, and the accelerated test is carried out at this high power source voltage. The various elements in the device are applied with proportionally higher voltage as related to the power source voltage in the overload test.

According to this invention, in the test, it is only necessary to apply the aforementioned test signals; hence, the burn-in test board with a complicated circuit configuration for generating the test signals as shown in Figure 13 is not needed in this case. In addition, since the test signals are small in number, the burn-in test board can be further simplified. Furthermore, since only the ON/OFF test signal is applied in the test, the test operation becomes very simple. Also, as pointed out in the above, for a variety of types of semiconductor devices, the pin position of the semiconductor device is the same for all of them for application of the test signals; this makes application of the test facility very simple since only one type of test board is needed.

As explained above, the test circuit in the field memory has a very simple configuration. Since this circuit is incorporated in the field memory or other semiconductor circuit, there is no problem related to the degree of integration.

In addition, since the test circuit is incorporated in the semiconductor device, it is also possible to carry out the aforementioned test in a simple way even after shipment.

Figures 11 and 12 show Application Example 2 of this invention.

Figure 11 shows the serial write clock SWCK generating circuit (8) and test data TDIN generating circuit (4A). Figure 12 shows the generation timing of serial write clock SWCK and test data TDIN.

Just like circuit (4) shown in Figure 6, test data TDIN generating circuit (4A) consists of inverter (42), TFF (43), DFF (44), (45) and inverter (48).

Serial write clock SWCK generating circuit (8) is made of inverters (81), (82), TFF (83), inverter (84) and TFF (85).

With the aid of power-on reset signal POR* (or clear signal CLR), said circuits (4A) and (8) are reset, and the operation is started. When power source voltage VDD is applied, the oscillator within the field memory acts and internal clock signal MF1 with a cycle of 780 ns is generated.

In the burn-in test, when testing is to be carried out at a serial write clock SWCK with a cycle of about 800 ns, that is, at a speed higher than the aforementioned 780 ns, two stages of TFF (83), (85) are used; when 780-ns internal clock MF1 is input, serial write clock SWCK with cycle of 800 ns is generated.

The generation operation of the test data TDIN is identical to the aforementioned operation. DFF (44), (45) are connected as 2 stages, and timing of test data TDIN and that of serial write clock SWCK are matched to each other in the test.

The operation of switching among the following signals is carried out in the same way as above: serial read clock SRCK, reset write pulse RSTW, reset read pulse RSTR, write enable WE, read enable RE, input enable IE, output enable OE, etc.

In Application Example 2, the power source voltage VDD is also higher than the conventional power source voltage so as to perform the burn-in test. In addition, the frequency of the serial write clock SWCK is also higher than the conventional frequency to carry out the burn-in test for the field memory. That is, the accelerated test is carried out with a more severe condition.

As described in the above, when this invention is implemented, it is possible to use various modified forms. For example, in the aforementioned example, the memory is used as an example of the semiconductor device. However, this invention is not limited to the memory, other types of semiconductor devices may also be used to implement this invention.

In the aforementioned application examples, the burn-in tests of the semiconductor device were shown as examples. However, this invention is not limited to burn-in testing, it is applicable for the other types of test.

In addition, in the above, the semiconductor devices described have the DIP type pin configuration. However, QFP and other pin configurations may also be used in this invention.

As described in the above, according to this invention, it is possible to carry out testing of the internal circuits of the semiconductor devices in the same way independent of the specific pin configurations of the semiconductor devices.

According to this invention, the number of types of signals applied to the semiconductor device under test can be reduced, and it is acceptable only to apply on/off logic signals that display the switching states; hence, the application configuration of the test signals can be simplified.

## Claims

1. A semiconductor device providing a functional circuit and having power supply terminals and a terminal for application of a clock characterised in that the device has a terminal for the application of a test mode control signal and a test signal generating circuit arranged to provide signals diagram which circuit functionality may be tested, said signals being coupled to said circuit in dependence upon said test mode control signal.

2. A semiconductor device as claimed in claim 1 and wherein said power supply terminals, said terminal for application of a clock signal and said terminal for the application of a test mode control signal are located at predetermined locations with respect to said device.

3. A semiconductor device as claimed in claim 2 and packaged such the said predetermined locations are provided by predetermined package terminals.

4. A semiconductor device as claimed in any preceding claim and wherein said test signal generating circuit is arranged to provide signal for a burn-in test.

5. A semiconductor device as claimed in any preceding claim and wherein said test signal generating circuit includes elements of said functional circuit.

6. A semiconductor device as claimed in any preceding claim and wherein said test mode control signal gates a signal present within said functional circuit between a normal regime and a test regime.

7. A semiconductor device as claimed in any of claims 2 to 6 being one of a family of devices, each member of said family being characterised by having said power supply terminals, said terminals for application of a clock signal and said terminal for the application of a test mode control signal respectively located at corresponding predetermined locations.

8. A semiconductor device as claimed in any preceding claim and wherein said functional circuit is a memory.

9. A semiconductor device as claimed in claim 8 and wherein said memory is organised in rows and columns.

10. A semiconductor device as claimed in claim 9 and wherein said test signal generating circuit includes row and column counters of said memory.

11. A semiconductor device as claimed in any of claims 8 to 10 and wherein said test signal generating circuit provides data to be stored in said memory.

12. A semiconductor device as claimed in any of claims 2 to 11 and having at least one output terminal at which the success of testing may be assessed, said output terminal being at a predetermined location with respect to said device.

13. A test method for a semiconductor device as claimed in any preceding claim and incluiding the steps of providing a power supply, a clock and a test mode control signal.

14. A test method as claimed in claim 13 and including the step of providing a supply at an increased level to stress the tested device during a burn-in test.

15. A test fixture for a semiconductor device as claimed in any of claims 1 to 12 including means for providing power supply, clock and test mode control signal connections to said device.

| 36-PIN DEVICE | 70-PIN DEVICE | | | 70-PIN DEVICE | 36-PIN DEVICE |
|---|---|---|---|---|---|
| I | I | V_DD | V_DD | 70 | 36 |
| | 2 | NC | NC | 69 | |
| 2 | 3 | TBIN | PPOR | 68 | 35 |
| | 4 | NC | NC | 67 | |
| 3 | 5 | PSWCK | NC | 66 | 34 |
| ⋮ | ⋮ | ⋮ | ⋮ | ⋮ | ⋮ |
| | 34 | NC | NC | 37 | |
| 18 | 35 | V_SS | V_SS | 36 | 19 |

*Fig. 1*

*Fig. 2*

*Fig. 3*

SWCK
WE
WCP
ISYS*
RSTBIN*
CNTW511*

Fig.4

RSTW
RSTR

BIN*

RSTBIN*

Fig.5

3

31

32

34

33

35

41 YWC*
SWCK YWC

4

RSTBIN*

42

43
CK
CK
Q
CLR

YWC*
YWC

44
D
CK
CK
Q
CLR

YWC*
YWC

45
D
CK
CK
Q
CLR
Q

46
TDIN

47

POR*

Fig.6

POR*
RSTBIN*
SWCK
TDIN(0~3)

Fig.7

8

Fig.8

Fig.9

Fig.10

Fig.11

MFI

POR

RSTBIN*

SWCK

TDIN

*Fig.12*

T1                    5V                              T2        7.5V

V_DD

|←t1→|                |←262263CLK→|

SWCK
(SRCK)

|←t2→|

DIN
0-3          0000              1111

|←0.5μs→|←0.5μs→|

SWCK,SRCK

|→0.2|←

RSTR,RSTW

DIN

*Fig.13*